# EUROPEAN PATENT APPLICATION

(11) **EP 1 873 223 A1**
(43) Date of publication of application: **02.01.2008**
(21) Application number: 06713515.2
(22) Date of filing: 10.02.2006
(51) Int. Cl.: C09K 3/10, C08K 3/22, C08L 63/00, C08L 71/02, H05B 33/04, H05B 33/10

(54) **RESIN COMPOSITION FOR SEALING MATERIAL, SEALING MATERIAL, SEALING METHOD AND ELECTROLUMINESCENT DISPLAY**

(30) Priority: 17.02.2005 JP 2005040008
(71) Applicant: Mitsui Chemicals, Inc., Tokyo 105-7117 (JP)
(72) Inventor: YAMAMOTO, Yugo, aura-shi, Chiba, 2990265 (JP); ITOU, Yuichi, aura-shi, Chiba, 2990265 (JP)
(74) Representative: HOFFMANN EITLE
(86) International application number: PCT/JP2006/302372
(87) International publication number: WO 2006/087979

(57) **Abstract**

Provided is a resin composition for sealing material containing 0.1 to 150 parts by weight of a curing agent (B) and 1 to 500 parts by weight of boehmite fine particles (C), based on 100 parts by weight of a compound (A) having polymerizable cyclic ether. Further provided according to the invention is a resin composition for sealing material having excellent water vapor permeation resistance and a sealing material for electroluminescence using the same.

## Description

### TECHNICAL FIELD

The present invention relates to a resin composition for sealing material which has excellent water vapor permeation resistance and acceptable productivity, and a sealing material for electroluminescence using the same.

### BACKGROUND ART

Recently, in the electronic and electric industries, flat panel displays have been developed and produced by using various types of display elements. In most of the displays, display elements are sealed in a glass or plastic cell. Representative examples may include liquid crystal (LC) displays and electroluminescent (EL) displays. An EL display is excellent in views of high luminance, high efficiency, and high-speed response, and has been watched as a next-generation flat panel display. As the element, an inorganic EL element or an organic EL element may be employed. The inorganic EL element has been put to practical use for backlights of clocks but there remains a need to overcome technical problems in order to achieve full coloring. The organic EL element is better than the inorganic EL element in views of high luminance, high efficiency, high-speed response, and multi-coloring, and has been put to practical use for displays of car audios or monitors for portable phones.

It is known that the organic EL element deteriorates due to water, and the sealing material of the electroluminescent display needs to have excellent water vapor permeation resistance. Practically, a structure where an organic EL element that is formed on a transparent substrate such as glass is sealed by using a glass- or metal-made sealing can. In this structure, the sealing material is used to attach the transparent substrate and the sealing can. For a sealing material for the organic EL, since the heat resistance of the organic EL element is low, a heat-curable sealing material that is cured at a heat resistance temperature of 80 to 120°C or less or a photo-curable sealing material that is capable of being cured at room temperature is used.
[Patent Document 1] JP-A No. 2002-53736
[Patent Document 2] JP-A No. H9-208809

### DISCLOSURE OF THE INVENTION

### Problems to be Solved by the Invention

It is an object of the invention to provide a resin composition for sealing material which has excellent water vapor permeation resistance and a sealing material for electroluminescence using the same.

### Means for Solving the Problems

The present inventors have studied extensively to solve above-mentioned problems, and as a result, they have found that when a resin composition contains boehmite fine particles, water vapor permeation resistance is significantly improved, which has led to completion of the invention. That is, the invention relates to a resin composition for sealing material, which contains 0.1 to 150 parts by weight of a curing agent (B) and 1 to 500 parts by weight of boehmite fine particles (C), based on 100 parts by weight of a compound (A) having polymerizable cyclic ether. The boehmite fine particles (C) is preferably in a plate shape. A resin composition for sealing material in which the component (A) is a compound containing at least one epoxy group in the molecule and the component (B) is a heat-curable curing agent, is preferable. Alternatively, a resin composition for sealing material in which the component (A) is a compound that contains at least one of epoxy group and oxetanyl group in the molecule, is preferable. The resin composition for sealing material may further contain a silane coupling agent (D). Further, according to the invention, it is possible to produce a sealing material for electroluminescence by using the resin composition for sealing material, an electroluminescent display by using the sealing material thereof, and a cured substance by using the resin composition for sealing material.

### Advantage of the Invention

According to the invention, it is possible to produce a resin composition for sealing material which has excellent water vapor permeation resistance and a sealing material for electroluminescence using the same.

### BEST MODE FOR CARRYING OUT THE INVENTION

Hereinafter, the invention will be described in detail.

### [Compound (A) having Polymerizable Cyclic Ether]

As the compound having polymerizable cyclic ether according to the invention, a compound having at least one of an epoxy group and an oxetanyl group as a functional group in one molecule thereof is used. Specific examples of the compound having polymerizable cyclic ether may include the following materials.

Examples of the compound that contains at least one epoxy group in a molecule thereof may include a monofunctional epoxy compound such as phenyl glycidyl ether, 2-ethylhexyl glycidyl ether, ethyldiethylene glycol glycidyl ether, dicyclopentadiene glycidyl ether, and 2-hydroxyethyl glycidyl ether, a bifunctional epoxy compound such as hydroquinone diglycidyl ether, resorcin diglycidyl ether, ethylene glycol diglycidyl ether, polyethylene glycol diglycidyl ether, 1,4-butanediol diglycidyl ether, 1,6-hexanediol diglycidyl ether, cyclohexanediol diglycidyl ether, cyclohexanedimethanol diglycidyl ether, dicyclopentadienediol diglycidyl ether, 1,6-naphthalenediol diglycidyl ether, bisphenol A diglycidyl ether, bisphenol F diglycidyl ether, hydrogenated bisphenol A diglycidyl ether, and hydrogenated bisphenol F diglycidyl ether, and a multifunctional epoxy compound such as trimethylolpropane triglycidyl ether, pentaerythritol tetraglycidyl ether, phenol novolak-type epoxy, and cresol novolak-type epoxy.

Furthermore, an alicyclic epoxy compound may be used as a compound that contains at least one epoxy group in a molecule thereof. Specifically, compounds that are represented by the following chemical formulae 1, 2, 3, and 4 may be used.

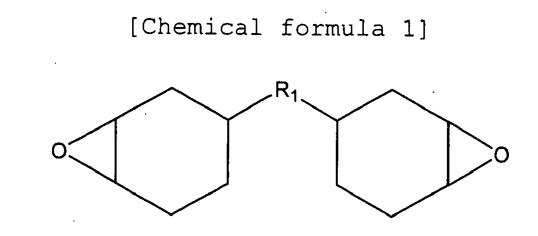

In chemical formula 1, R₁ is an oxygen atom; a sulfur atom; a linear or branched alkylene group having 1 to 20 carbon atom(s) such as a methylene group, an ethylene group, a propylene group, and a butylene group; a linear or branched poly(alkyleneoxy) group having 1 to 120 carbon atom(s) such as a poly(ethyleneoxy) group and a poly(propyleneoxy) group; a linear or branched unsaturated hydrocarbon group such as a propenylene group, a methylpropenylene group, and a butenylene group; a carbonyl group; an alkylene group containing a carbonyl group; or an alkylene group having a carbamoyl group in the molecular chain.

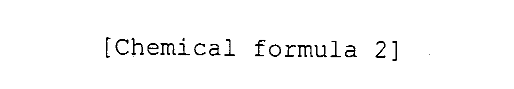

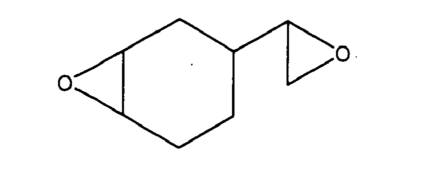

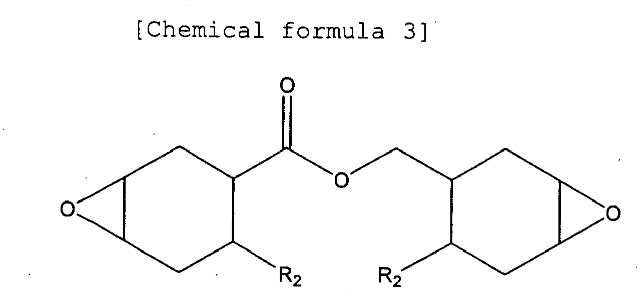

In chemical formula 3, R₂ is a hydrogen atom; a fluorine atom; an alkyl group having 1 to 6 carbon atom(s) such as a methyl group, an ethyl group, a propyl group, a butyl group, a pentyl group, and a hexyl group; a fluoroalkyl group having 1 to 6 carbon atom(s) such as a trifluoromethyl group, a perfluoromethyl group, a perfluoroethyl group, and a perfluoropropyl group; an aryl group having 6 to 18 carbon atoms such as a phenyl group and a naphthyl group; a furyl group; or a thienyl group. R₂s may or may not be the same.

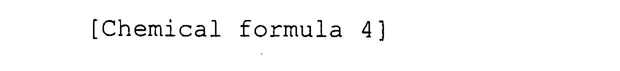

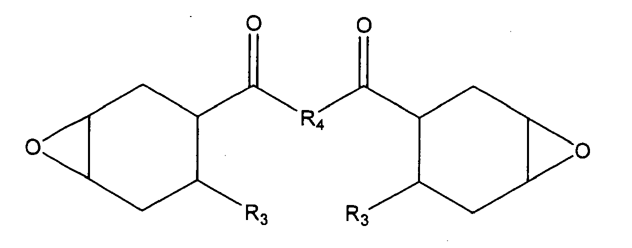

In chemical formula 4, R₃ is a hydrogen atom; a fluorine atom; an alkyl group having 1 to 6 carbon atom(s) such as a methyl group, an ethyl group, a propyl group, a butyl group, a pentyl group, and a hexyl group; a fluoroalkyl group having 1 to 6 carbon atom(s) such as a trifluoromethyl group, a perfluoromethyl group, a perfluoroethyl group, and a perfluoropropyl group; an aryl group having 6 to 18 carbon atoms such as a phenyl group and a naphthyl group; a furyl group; or a thienyl group. R₃s may or may not be the same. R₄ is an oxygen atom; a sulfur atom; a linear or branched alkylene group having 1 to 20 carbon atom(s) such as a methylene group, an ethylene group, a propylene group, and a butylene group; a linear or branched poly(alkyleneoxy) group having 1 to 120 carbon atom(s) such as a poly(ethyleneoxy) group and a poly(propyleneoxy) group, a linear or branched unsaturated hydrocarbon group such as a propenylene group, a methylpropenylene group, and a butenylene group; a carbonyl group; an alkylene group containing a carbonyl group; or an alkylene group containing a carbamoyl group in the molecular chain.

Further, the hydrogen atoms of the carbon-hydrogen bonds in the compound of chemical formulae 1 to 4 may be partially or completely substituted by fluorine. More specifically, examples of the compound may include a compound (bisphenol AF diglycidyl ether) in which six hydrogen atoms of the methyl group in bisphenol A glycidyl ether are substituted by fluorine; a reaction product of a compound, in which six hydrogen atoms of the methyl group in bisphenol A are substituted by fluorine, with an epoxy compound; and the like.

Examples of the compound containing at least one oxetanyl group in the molecule thereof may include a monofunctional oxetane compound such as 3-ethyl-3-hydroxymethyloxetane, (3-ethyl-3-oxetanylmethoxy)methylbenzene, [1-(3-ethyl-3-oxetanylmethoxy)ethyl]phenyl ether, 2-ethylhexyl(3-ethyl-3-oxetanylmethyl) ether, dicyclopentadiene(3-ethyl-3-oxetanylmethyl) ether, and 2-hydroxyethyl(3-ethyl-3-oxetanylmethyl) ether; a bifunctional oxetane compound such as bis(3-ethyl-3-methyloxetane) ether, 1,4-bis[(3-ethyl-3-oxetanylmethoxy)methyl]benzene, 1,3-bis[(3-ethyl-3-oxetanylmethoxy)methyl]benzene, dicyclopentenyl bis(3-ethyl-3-oxetanylmethyl) ether, triethylene glycol bis(3-ethyl-3-oxetanylmethyl) ether, bisphenol A bis(3-ethyl-3-oxetanylmethyl) ether, and bisphenol F bis(3-ethyl-3-oxetanylmethyl) ether; and a multifunctional oxetane compound such as a (3-ethyl-3-oxetanylmethyl) ether compound of a phenol novolak resin and a (3-ethyl-3-oxetanylmethyl) ether compound of a cresol novolak resin.

### [(B) Curing agent]

Examples of the curing agent (B) according to the invention are not limited and any curing agent may be used as long as the curing agent is a heat-curable curing agent that is capable of being cured at a heat resistance temperature of an organic EL element, that is, 80 to 120°C, or at the heat resistance temperature or less, or a cationic polymerization initiator that is capable of initiating cationic polymerization by using light or heat.

A substance that is used to cure an epoxy resin by heating may be used as a heat-curable curing agent. Specific examples of the substance include a polyamine-based curing agent such as diethylenetriamine, triethylenetetramine, N-aminoethyl piperazine, diaminodiphenylmethane, and adipic acid dihydrazide; an acid anhydride-based curing agent such as phthalic anhydride, tetrahydrophthalic anhydride, hexahydrophthalic anhydride, methyltetrahydrophthalic anhydride, methylhexahydrophthalic anhydride, and an anhydrous methyl nadic acid; a phenol novolac type curing agent; a polymercaptan curing agent such as trioxanetritylene mercaptan; a tertiary amine compound such as benzyldimethylamine and 2,4,6-tris(dimethylaminomethyl)phenol; and an imidazole compound such as 2-methylimidazole, 2-ethyl-4-methylimidazole, and 1-benzyl-2-methylimidazole. Furthermore, a solid-dispersion type latent curing agent or a latent curing agent that is included in microcapsules may be used.

As to the curing agent, in order to perform the curing at the heat resistance temperature of the organic EL element or less, a curing enhancer may be additionally used. In the case where the curing agent (B) is a heat-curable curing agent, a compound that contains at least one epoxy group in a molecule thereof is used as the compound (A) having polymerizable cyclic ether.
The cationic polymerization initiator is not limited, and examples thereof may include a cationic polymerization initiator that initiates cationic polymerization by using light and a cationic polymerization initiator that initiates polymerization by using heat.

The cationic initiator that initiates the cationic polymerization by using light may be a compound that optically reacts and emits a Lewis acid, and examples thereof may include onium salts that include onium ions and anions.
Examples of the onium ions may include diphenyliodonium, 4-methoxydiphenyliodonium, bis(4-methylphenyl)iodonium, bis(4-tert-butylphenyl)iodonium, bis(dodecylphenyl)iodonium, tolylcumyliodonium, triphenylsulfonium, diphenyl-4-thiophenoxyphenylsulfonium, bis[4-(diphenylsulfonio)-phenyl]sulfide, bis[4-(di(4-(2-hydroxyethyl)phenyl)sulfonio)-phenyl]sulfide, η 5-2,4-(cyclopentadienyl)[1,2,3,4,5,6-η-(methylethyl)benzene]-iron (1+), and the like.

Examples of the anions may include tetrafluoroborate, hexafluorophosphate, hexafluoroantimonate, hexafluoroarsenate, hexachloroantimonate, and the like.
Furthermore, a perchloric acid ion, a trifluoromethanesulfonic acid ion, a toluenesulfonic acid ion, a trinitrotoluenesulfonic acid ion, and the like may be used as the anions. The above-mentioned anions may be replaced with aromatic anions.

Specific examples thereof may include tetra(fluorophenyl)borate, tetra(difluorophenyl)borate, tetra(trifluorophenyl)borate, tetra(tetrafluorophenyl)borate, tetra(pentafluorophenyl)borate, tetra(perfluorophenyl)borate, tetra(trifluoromethylphenyl)borate, tetra(di(trifluoromethyl)phenyl)borate, and the like.

In addition, the cationic polymerization initiator that initiates the polymerization by using heat may be used. For example, a Lewis acid complex such as a BF₃ complex may be used.
These cationic initiators may be used singly or in combination of two or more kinds. In the case where the curing agent (B) is a cationic polymerization initiator, a compound that contains at least one epoxy group or oxetanyl group in a molecule thereof may be used as the compound (A) having polymerizable cyclic ether.

The content of the curing agent component (B) in the resin composition according to the invention is generally 0.1 to 150 parts by weight based on 100 parts by weigh of the component (A). In the case where the curing agent (B) is a heat-curable curing agent, the content may depend on the type of curing agent. In respect to a polyamine based curing agent, an acid anhydride based curing agent, a phenol novolac type curing agent, and a polymercaptan curing agent which are used in almost stoichiometrical quantity, the content may be generally 50 to 150 parts by weight based on 100 parts by weight of the component (A).

Meanwhile, in the case where the curing agent (B) is a heat-curable curing agent such as a tertiary amine compound and an imidazole compound, or a cationic polymerization initiator, the content is generally 0.1 to 50 parts by weight, and in consideration of elution of the curing agent after the curing, preferably 0.1 to 10 parts by weight, based on 100 parts by weight of the component (A).
The curing may start immediately after the mixing with the compound (A) having polymerizable cyclic ether in accordance with the reactivity of the curing agent (B). In this case, the component (A) and the component (B) may be separately stored, and mixed immediately before they are used such be used as a two-liquid mixing sealing material.

### [(C) Boehmite fine particle]

The boehmite fine particle (C) according to the invention is a compound that is represented by the following chemical formula 6.

[Chemical formula 6] Al₂O₃·H₂O or AlO(OH)

The boehmite fine particles in the resin composition are identified by using X-ray photoelectron spectroscopy (XPS) and X-ray diffractometry.

For example, the boehmite fine particles in the resin composition are identified by using the following method. That is, the resin composition is subjected to heat treatment at high temperature (for example, about 300°C) to completely burn organic components and recover inorganic components of the resin composition.
An element composition ratio of the recovered inorganic components is obtained by using the XPS. If boehmite fine particle elemental substances are measured using the XPS, the element composition has C:O:Al = 6.8:61.7:29.7 (atm%). However, in the case where the boehmite fine particles are used in conjunction with other fillers, the element composition ratio of Al is in the range of 10 to 70 atm%.

Furthermore, the recovered inorganic components were subjected to X-ray diffraction. Pure boehmite has a sharp characteristic diffraction peak at 2θ = 14°, but in the case where the boehmite fine particles are used in conjunction with other fillers, the diffraction peak is in the range of 2θ = 12 to 16°.
The shape of the boehmite fine particle is not limited, and may be generally a granule, a needle, or a plate.
According to the study that is made by the present inventors, in the case where the particles having the plate shape are used, water vapor permeation resistance is significantly improved and the particles are useful to the resin composition for sealing material. Among the boehmite fine particles having the plate shape, each particle has an aspect ratio in the range of preferably 10 to 60, and more preferably 40 to 50. If the aspect ratio is in the above-mentioned range, the water vapor permeation resistance is apt to be improved.

The particle diameter of the boehmite fine particle is not limited, but the average particle diameter may be generally in the range of 0.5 to 10 µm. However, in the case where the thickness of the sealing material is set when a substrate and a sealing can are attached to each other by using the sealing material, if the particles that are larger than the thickness are contained, since there is the case that the sealing material does not have a predetermined thickness, it is preferable to use the boehmite fine particles having the particle diameter smaller than the thickness of the sealing material. In addition, the boehmite fine particles may or may not be subjected to surface treatment. Examples of the surface treatment may include methoxy group formation, trimethylsilyl group formation, octylsilyl group formation, and surface treatment using silicon oil.

These boehmite fine particles (C) may be used singly or in combination of two or more kinds.
The content of the boehmite fine particles (C) is generally 1 to 500 parts by weight, preferably 10 to 200 parts by weight, and more preferably 20 to 100 parts by weight, based on 100 parts by weight of the component (A). The content of the boehmite fine particles (C) may be controlled according to the viscosity of the sealing material in the above-mentioned range. If the content of the boehmite fine particles (C) is in the above-mentioned range, the water vapor permeation resistance of the resin composition for sealing material is improved.

### [(D) Silane coupling agent]

A coupling agent may be added to the resin composition according to the invention in order to improve the surface adhesion to the substrate. Examples of the coupling agent may include the compounds that are represented by the following chemical formulae 7 and 8.

[Chemical Formula 7] (R₂O)₃-Si-R₃R₄

[Chemical Formula 8] (R₂O)₃-Ti-R₃R₄

In chemical formulae 7 and 8, R₂ is an alkylene group such as a methyl group, an ethyl group, and a propyl group. R₃ is a linear or branched alkylene group having 1 to 20 carbon atom(s) such as a methylene group, an ethylene' group, a propylene group, and a butylene group; a linear or branched poly(alkyleneoxy) group having 1 to 120 carbon atom(s) such as a poly(ethyleneoxy) group and a poly(propyleneoxy) group; a linear or branched unsaturated hydrocarbon group such as a propenylene group, a methylpropenylene group, and a butenylene group; a carbonyl group; an alkylene group containing a carbonyl group; an alkylene group containing a carbamoyl group in the molecular chain; or a phenyl group containing a carbamoyl group in the molecular chain. R₄ is an alkylene group such as a methyl group, an ethyl group, and a propyl group, a glycidyl ether group, a primary amino group, a thiol group, a vinyl group, or an isocyanate group. These coupling agents in which the hydrogen atoms of the carbon-hydrogen bonds are partially or completely substituted by fluorine may be used. Preferably, a material in which hydrogen atoms are partially or completely substituted by fluorine in a methylene group and/or a methyl group is used.

In the case where the silane coupling agent (D) is used, the content is generally from 0.1 to 30 parts by weight based on 100 parts by weight of the component (A).

### [Preparation of the resin composition]

The photo-curable resin composition according to the invention is produced so that compositions are homogeneously mixed with each other. The viscosity may be regulated by controlling a mixing ratio of the resin or adding other components. When the viscosity is high, kneading may be performed through a routine procedure by using three rolls.
The viscosity is in the range of 1 to 500 Pa·s at 25°C (a measurement method of viscosity: JISZ8803).

### [Sealing process]

There is no specific limitation in the process of applying the sealing agent on a display substrate as long as the sealing agent is uniformly applied. For example, a known process such as screen printing or application using a dispenser may be carried out. After the application of the sealing agent, the display base substrate is subjected to attachment, heating, or light radiation, and the sealing agent is cured. In the case of the heat curing, for example, storing is performed in a constant-temperature bath at 100°C for 1 hour while fixing is carried out, thereby the curing is achieved. In the case of the photo-curing, any light source may be used as long as the light source is capable of achieving the curing for a predetermined operation time. Usually, the light source that is capable of radiating ultraviolet rays or rays in a visible region is used. More specifically, a low pressure mercury lamp, a high pressure mercury lamp, a xenon lamp, a metal halide lamp, and the like may be used. In general, the quantity of light radiated may be suitably determined in the range where no uncured resin composition remains or no adhesion failure is brought about. However, the quantity of light is usually 500 to 9000 mJ/cm². There is no specific upper limit of the quantity of light for the radiation, but excessive large quantity of light is not preferable because of waste of energy and low productivity. Through the above-mentioned procedure, the curing reaction is performed to produce cured substances from the resin composition for sealing material.

### EXAMPLES

Hereinafter, Examples of the invention will be described, which are not intended to limit the invention.

### <Measuring method>

The obtained resin compositions and cured substances were evaluated by using the following methods.

### (Viscosity)

The viscosity of the resin compositions was measured at 25°C using an E type viscometer (RC-500 manufactured by Toki Sangyo Co. Ltd.).

### (Moisture permeability of films)

The moisture permeability of films (thickness: 100 µm) of the resin compositions which were cured by heating or UV radiation was obtained in accordance with JIS Z0208 under the conditions of 80°C and 95% RH.

### <Raw materials>

The compound having polymerizable cyclic ether: bisphenol F diglycidyl ether (trade name EXA-830LVP, manufactured by Dainippon Ink and Chemicals, Inc.), and 1,4-bis[(3-ethyl-3-oxetanylmethoxy)methyl]benzene (trade name OXT-121, manufactured by Toagosei Co., Ltd.)

The curing agent: tolylcumyliodonium tetra(pentafluorophenyl) borate (trade name: RHODORSIL PHOTOINITIATOR 2074, manufactured by RHODIA), and tetrahydromethyl phthalic anhydride (trade name: Epicure YH300, manufactured by JAPAN EPOXY RESINS Co., Ltd.)

The boehmite fine particles: boehmite fine particles having a plate shape (trade name: Serasyuru BMF aspect ratio catalogue value 40 to 50, manufactured by KAWAI LIME INDUSTRY Co., Ltd., and trade name: Serasyuru BMM aspect ratio catalogue value 10 to 15, manufactured by KAWAI LIME INDUSTRY Co., Ltd.), and boehmite fine particles having a needle shape (trade name: Serasyuru BMI, manufactured by KAWAI-LIME INDUSTRY Co., Ltd.)

The silane coupling agent: γ-glycidoxypropyltrimethoxysilane (trade name: SH6040, manufactured by Toray Dow Corning silicone Co., Ltd.)

The cationic polymerizable compound; bisphenol F diglycidyl ether (trade name EXA-830LVP, manufactured by Dainippon Ink and Chemicals, Inc.), and 1,4-bis[(3-ethyl-3-oxetanylmethoxy)methyl]benzene (trade name: OXT-121, manufactured by Toagosei Co., Ltd.)

The fine particle inorganic filler: fine particle alumina (trade name: ADMAFINE AE-2050, manufactured by ADMATECHS Co., Ltd.), and fine particle talc (trade name: SG-2000, manufactured by Nippon Talc Co., Ltd.)

### [Example 1]

### (Preparation of the resin composition)

According to the formulation shown in Table 1, the compound having polymerizable cyclic ether, the curing agent, the boehmite fine particles, the coupling agent, and the fine particle inorganic filler were kneaded by using three rolls to obtain a liquid composition.

### (Production of the resin composition film)

Two glass plates that were treated with a fluorine-based release agent (trade name: DAIFREE GA-6010, manufactured by DAIKIN INDUSTRIES, Ltd.) were prepared. A Teflon (designated trademark) sheet that was cut so as to have a strip shape and a thickness of 100 µm was disposed on the circumference of the glass plate, and the obtained resin composition was applied on the resulting glass plate. Next, another glass plate that was treated with a release agent was layered, the resin composition and the Teflon (designated trademark) sheet disposed on the circumference were interposed between two glass plates, and a portion on which the Teflon (designated trademark) sheet was disposed was fixed by using clips. These were left in a constant-temperature bath at 100°C for 1 hour to cure the liquid resin composition. Next, these were drawn from the constant-temperature bath, and the glass plates were separated from each other to obtain a resin composition film. The obtained resin composition was 100 µm in thickness.

### [Examples 2 to 6 and Comparative Examples 1 to 6]

According to the formulation shown in Table 1, a resin composition was prepared in the same manner as in Example 1, except that the component having the composition shown in Table 1 was used in an amount shown in Table 1. In Examples 3 and 5 and Comparative Examples 1, 2, and 3, the resin composition film was produced in accordance with the procedure same as in Example 1.

In Examples 2, 4, and 6 and Comparative Examples 4, 5, and 6, the resin composition film was produced in accordance with the following procedure.
In respect to the obtained liquid composition, as in Example 1, the resin composition and the Teflon (designated trademark) sheet disposed on the circumference were interposed between two glass plates, and a portion on which the Teflon (designated trademark) sheet is disposed was fixed with clips. Next, energy of 3000 mJ/cm² was radiated by using a metal halide lamp for 30 sec to cure the liquid composition. Next, the glass plates were separated from each other to obtain a resin composition film. The obtained resin composition was 100 µm in thickness.

Various evaluations were performed in respect to the resin compositions shown in Table 1. The results are shown in Tables 1 and 2.

**[TABLE 1]**

| | Examples | | | | | |
|---|---|---|---|---|---|---|
| | 1 | 2 | 3 | 4 | 5 | 6 |
| (A) Compound having polymerizable cyclic ether | | | | | | |
| · bisphenol F glycidyl ether | 100 | 80 | 100 | 80 | 100 | 80 |
| · 1,4-bis [(3-ethyl-3- oxetanylmethoxy)methyl]benzene | - | 20 | - | 20 | - | 20 |
| (B) Curing agent | | | | | | |
| · tolylcumyliodonium tetra(pentafluorophenyl)borate | - | 3 | - | 3 | - | 3 |
| · tetrahydromethylphthalic anhydride | 100 | - | 100 | - | 100 | - |
| (C) Inorganic boehmite fine particle | | | | | | |
| · boehmite fine particle having a needle shape | 60 | 30 | - | - | - | - |
| · boehmite fine particle having a plate shape, aspect ratio of 10 to 15 | - | - | 60 | 30 | - | - |
| · boehmite fine particle having a plate shape, aspect ratio of 40 to 50 | - | - | - | - | 60 | 30 |
| Inorganic fine particle | | | | | | |
| · fine particle alumina | - | - | - | - | - | - |
| · fine particle talc | - | - | - | - | - | - |
| (D) Coupling agent · γ-glycidoxypropyltrimethoxysilane | 4 | 2 | 4 | 2 | 4 | 2 |
| Viscosity (Pa·s) | 3 | 40 | 2 | 12 | 2 | 6 |
| Moisture permeability (80°C 95% RH) | 82 | 74 | 79 | 71 | 65 | 62 |

**[TABLE 2]**

| | Comparative Examples | | | | | |
|---|---|---|---|---|---|---|
| | 1 | 2 | 3 | 4 | 5 | 6 |
| (A) Compound having polymerizable cyclic ether | | | | | | |
| · bisphenol F glycidyl ether | 100 | 100 | 100 | 80 | 80 | 80 |
| · 1,4-bis [(3-ethyl-3-oxetanylmethoxy)methyl]benzene | - | - | - | 20 | 20 | 20 |
| (B) Curing agent | | | | | | |
| · tolylcumyliodoniumtetra (pentafluorophenyl)borate | - | - | - | 3 | 3 | 3 |
| · tetrahydromethyl phthalic anhydride | 100 | 100 | 100 | - | - | - |
| (C) Inorganic boehmite fine particle | | | | | | |
| · boehmite fine particle having a needle shape | - | - | - | - | - | - |
| · boehmite fine particle having a plate shape, aspect ratio of 10 to 15 | - | - | - | - | - | - |
| · boehmite fine particle having a plate shape, aspect ratio of 40 to 50 | - | - | - | - | - | - |
| Inorganic fine particle | | | | | | |
| · fine particle alumina | 60 | - | - | 30 | - | - |
| · fine particle talc | - | 60 | - | - | 30 | - |
| (D) Coupling agent · γ-glycidoxypropyltrimethoxysilane | 4 | 4 | 4 | 2 | 2 | 2 |
| Viscosity (Pa·s) | 3 | 3 | 1 | 50 | 6 | 6 |
| Moisture permeability (80°C 95% RH) | 154 | 124 | 251 | 148 | 112 | 187 |

### Industrial Applicability

Since a sealing material having excellent water vapor permeation resistance is provided, the invention can be applied to various fields including electronic materials.

## Claims

1. A resin composition for sealing material, comprising:
0.1 to 150 parts by weight of a curing agent (B); and
1 to 500 parts by weight of boehmite fine particles (C), based on 100 parts by weight of a compound (A) having polymerizable cyclic ether.

2. The resin composition for sealing material according to claim 1, wherein the boehmite fine particles (C) have a plate shape.

3. The resin composition for sealing material according to claim 1, further comprising a silane coupling agent (D).

4. The resin composition for sealing material according to claim 1, further comprising:
0.1 to 30 parts by weight of the silane coupling agent (D) based on 100 parts by weight of the compound (A) having polymerizable cyclic ether.

5. The resin composition for sealing material according to claim 1, wherein the compound (A) having polymerizable cyclic ether is a compound that contains at least one epoxy group in the molecule, and wherein the curing agent (B) is a heat-curable curing agent.

6. The resin composition for sealing material according to claim 1, wherein the compound (A) having polymerizable cyclic ether is a compound that contains at least one of epoxy group and oxetanyl group in the molecule, and wherein the curing agent (B) is a cationic polymerization initiator.

7. A sealing material for an electroluminescent display, comprising the resin composition of claim 1.

8. A method of sealing an electroluminescent display by using a sealing material containing the resin composition of claim 1.

9. An electroluminescent display which is obtained through sealing by using a sealing material containing the resin composition of claim 1.

10. A cured substance which is obtained by using the resin composition of claim 1.
